Europäisches Patentamt

European Patent Office

Office européen des brevets

(19)

(11) EP 1 615 043 A1

(12) EUROPEAN PATENT APPLICATION
published in accordance with Art. 158(3) EPC

(43) Date of publication:
11.01.2006 Bulletin 2006/02

(51) Int Cl.:
G01R 31/36 (1980.01)

(21) Application number: 04722648.5

(22) Date of filing: 23.03.2004

(86) International application number:
PCT/JP2004/003925

(87) International publication number:
WO 2004/088342 (14.10.2004 Gazette 2004/42)

(84) Designated Contracting States:
AT BE BG CH CY CZ DE DK EE ES FI FR GB GR
HU IE IT LI LU MC NL PL PT RO SE SI SK TR
Designated Extension States:
AL LT LV MK

(30) Priority: 31.03.2003 JP 2003974463

(71) Applicant: YAZAKI CORPORATION
Minato-ku
Tokyo 108-8333 (JP)
(72) Inventors:
• ARAI, Yoichi,
c/o Yazaki Corporation
Susono-shi, Shizuoka 410-1194 (JP)
• MIYAZAKI, Yoshiya,
c/o Yazaki Corporation
Susono-shi, Shizuoka 410-1194 (JP)

(74) Representative: Viering, Jentschura & Partner
Steinsdorfstrasse 6
80538 München (DE)

(54) BATTERY STATUS MONITORING APPARATUS AND METHOD

(57) A microcomputer 23 monitors the battery condition by detecting a first deterioration degree caused by increase of an internal resistance of a battery 13 and a second deterioration degree caused by inactivation of an activation material in the battery 13 based on outputs of a current sensor 15 and a voltage sensor 17.

FIG. 1

**Description**

BACKGROUND OF THE INVENTION

Field of the Invention

This invention relates to a battery deterioration degree monitor and a method of that, especially a battery deterioration degree monitor for monitoring deterioration degree of the battery and a method of that.

Description of the Related Art

The battery for a vehicle installed in the vehicle is applied widely as an electric power source for engine starting or operation of electric devices in the vehicle. Therefore, recognizing charge condition of the battery is very important.
When repeating charge-and-discharge in the battery, a terminal voltage of the battery is gradually decreased. Therefore, for recognizing securely the charge condition, it is a very important obj ect to recognize the latest deterioration condition (deterioration degree) of the battery. Usually, by detecting a direct-current resistance (ohmic resistance) of the battery, as a part of the internal resistance which is not changed by a discharge current or a discharge time, the deterioration degree to be an indicator of deterioration is obtained based on the detected direct-current resistance.

SUMMARY OF THE INVENTION

Objects to be solved

As causes of increasing the internal resistance of the battery, there are reversible deterioration generated temporarily by temperature change and irreversible deterioration generated by that inactivation of an active material caused by corrosion of a lattice, sulfation and drop of the active material during repeat of charge/discharge.
Therefore, by monitoring the deterioration to cause increase of the internal resistance, the deterioration including the reversible deterioration and the irreversible deterioration mentioned above can be monitored. However, by monitoring only the deterioration to cause increase of the internal resistance, the irreversible deterioration generated by repeat of charge/discharge cannot be monitored, so that the battery condition cannot be monitored securely.
To overcome the above problem, objects of the present invention are to provide a battery condition monitor, which can monitor a battery condition securely and a method of monitoring the battery condition.

How to attain the object of the present invention

In order to attain the object, a battery condition monitor for monitoring a condition of a battery according to claim 1 of the present invention includes a first deterioration detector for detecting a first deterioration degree cause by increase of an internal resistance of the battery, and a second deterioration detector for detecting a second deterioration degree caused by decrease of active material of the battery to cause decrease of a charge capacity of the battery, and the condition of the battery is monitored based on the first deterioration degree and the second deterioration degree.
A method of monitoring a battery condition according to claim 4 of the present invention has a step of monitoring the battery condition based on a first deterioration degree caused by increase of an internal resistance of the battery and a second deterioration degree indicating a decreasing value of active material of the battery to cause decrease of a charge capacity of the battery.
According to claim 1 or 4 of the present invention, the first deterioration degree caused by increase of the internal resistance of the battery and the second deterioration degree caused by decrease of the active material of the battery to cause decrease of the charge capacity of the battery are monitored. The condition of the battery is monitored based on the first deterioration degree and the second deterioration degree. The deterioration including the reversible deterioration and the irreversible deterioration can be monitored by the first deterioration degree, and the irreversible deterioration can be monitored by the second deterioration degree.
The battery condition monitor according to claim 2 of the present invention is characterised in the battery condition monitor as claimed in claim 1 , in that the first deterioration detector obtains a direct-current resistance of the battery based on a discharge current and terminal voltage of the battery detected in a high-rate discharging, and obtains a saturated polarization, as a saturated value of a voltage drop by the internal resistance other than the direct-current resistance of a terminal voltage, based on the discharge current and the terminal voltage of the battery detected in discharging, and the direct-current resistance of the battery, and detects the first deterioration degree based on the direct-current resistance and the saturated polarization.
According to claim 2 of the present invention, the first deterioration detector obtains the direct-current resistance of the battery based on the discharge current and terminal voltage of the battery detected in the high-rate discharging, and obtains the saturated polarization, as the saturated value of a voltage drop by the internal resistance other than the direct-current resistance of a terminal voltage, based on the discharge current and the terminal voltage of the battery detected in discharging, and the direct-current resistance of the battery, and detects the first deterioration degree based on the direct-current resistance and the saturated polarization.

Therefore, only by detecting the discharge current and the terminal voltage of the battery in various discharging, and processing detected results, the direct-current resistance and the saturated polarization can be obtained. By obtaining the saturated polarization, the first deterioration degree at a point, which a dischargeable capacity decreases to the smallest when the discharge continues, can be monitored.

The battery condition monitor according to claim 3 of the present invention is characterised in the battery condition monitor as claimed in claim 1 or 2 in that the second deterioration detector detects the second deterioration based on the decreasing value of the charge capacity at full-charge of the battery at any time corresponding to the charge capacity at full-charge of the new battery.

According to claim 3 of the present invention, the second deterioration detector detects the second deterioration based on the decreasing value of the charge capacity at full-charge of the battery at any time corresponding to the charge capacity at full-charge of the new battery. Therefore, by obtaining the decreasing value of the charge capacity at full-charge, the second deterioration degree can be easily obtained.

BRIEF DESCRIPTION OF THE DRAWINGS

Fig. 1 is a block diagram of one embodiment of a battery condition monitor performing a method of detecting a dischargeable capacity and a method of monitoring a battery condition according to the present invention;

Fig. 2 is a graph showing one example of a discharge current with a rush current at starting of driving a starter motor;

Fig. 3 is a graph showing an example of characteristics of I-V by an approximate quadratic equation;

Fig. 4 is a graph showing an example of method of deleting a part by concentration polarization from an approximate equation of increasing;

Fig. 5 is a graph showing an example of a method of deleting a part by concentration polarization from an approximate equation of decreasing;

Fig. 6 is a graph showing an example of characteristics of I-V by an approximate linear equation of increasing;

Fig. 7 is a graph showing an example of the other method of deleting a part by concentration polarization from an approximate equation of decreasing;

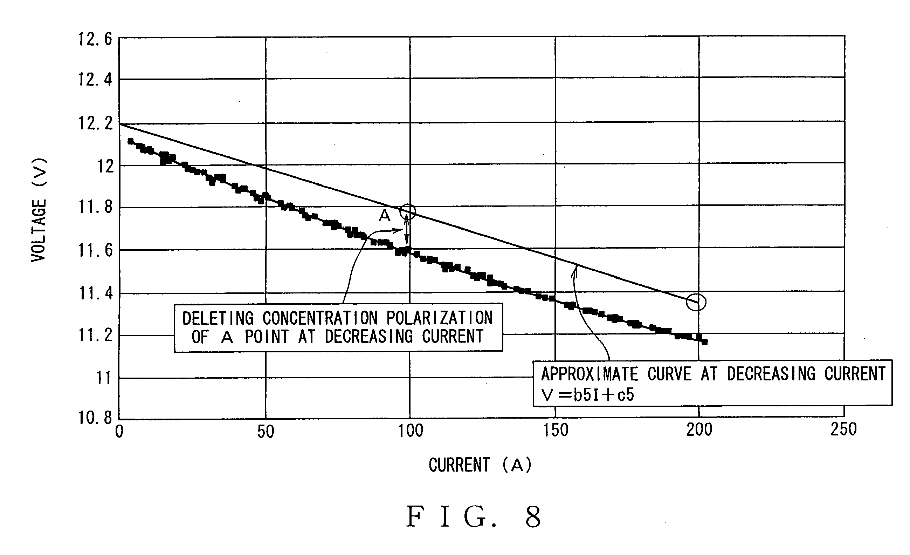

Fig. 8 is a graph showing an example of a furthermore method of deleting a part by concentration polarization from an approximate equation of decreasing;

Fig. 9 is a graph for explaining a method of obtaining a saturated polarization in discharging in a balanced condition or a condition having discharging polarization.

DESCRIPTION OF THE PREFERRED EMBODIMENT

An embodiment of a battery condition monitor acting a method of monitoring a battery condition according to the present invention will be described with reference to figures. Before that, a method of obtaining a direct-current resistance of the battery will be described for calculating a first deterioration degree (call SOH1 hereafter) to cause increase of an internal resistance of the battery.

In a 12V car, a 42V car, an EV car and an HEV car having a battery, a constant load such as a starter motor, a motor generator and a drive motor, which requires large current, is installed as a vehicle load acting by supplied power from the battery. When a large current constant load like the starter motor is turned ON, after a rush current flows in the constant load, a constant current corresponding to a value of the load flows. When the load is a lamp, the rush current is called an inrush current.

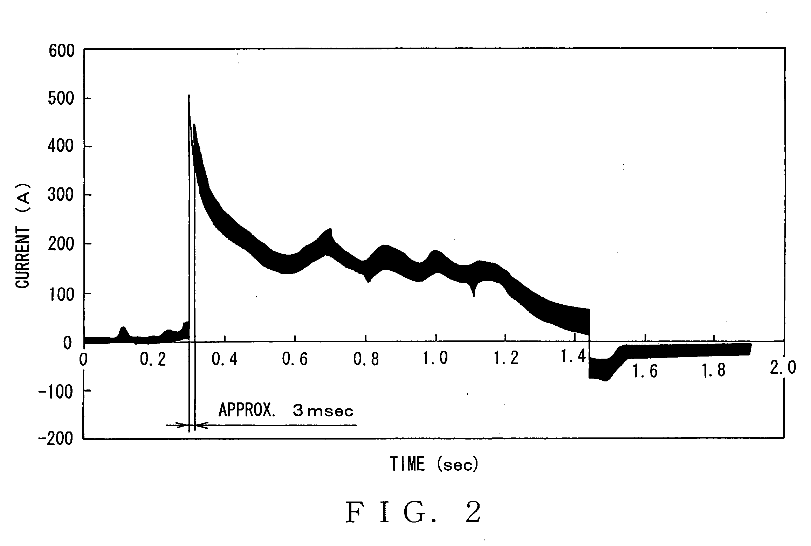

When a direct-current motor is applied to the starter motor, the rush current flowing in a field coil increases from zero to a peak value as few times large as that of the constant current, for example 500 [A] , monotonously in a short time such as 3 msec. just after starting driving the constant load as shown in Fig. 2. After that, the current decreases from the peak value to the constant value corresponding to the constant load monotonously in a short time such as 150 msec. Thus, the current is supplied as a discharge current by the battery. Therefore, by measuring the discharge current of the battery and a terminal voltage corresponding to the discharge current when the rush current flows in the constant load, characteristics of the discharge current (I) of the battery and the terminal voltage (V), which shows a change of the terminal voltage against a wide-range change of the current from zero to the peak value, can be measured.

The battery is discharged by an electronic load, in which the current increases from zero to 200[A] in 0.25 sec.

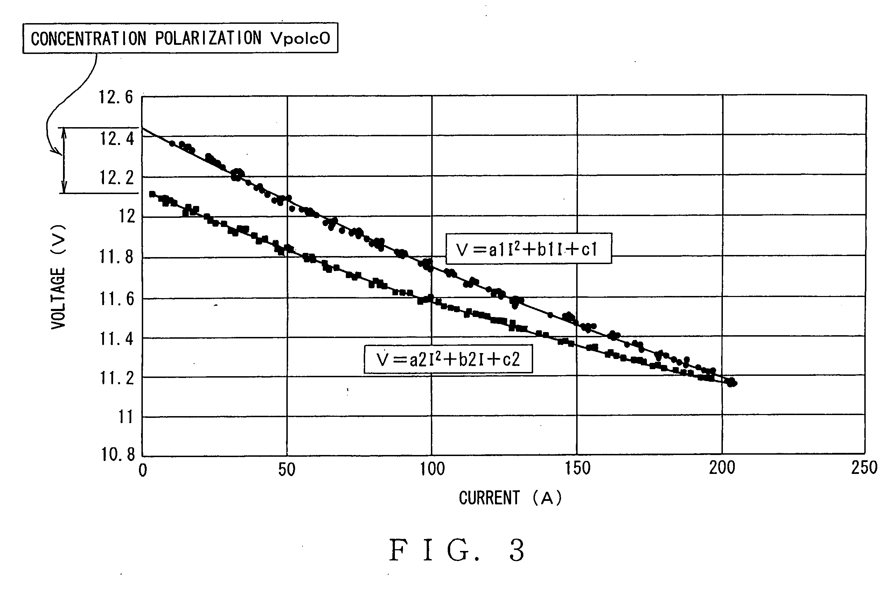

and decreases from the peak value to zero in the same time, as a approximated discharge corresponding to the rush current flowing when the starter motor is turned ON. By measuring a pair of the discharge current of battery and the terminal voltage in a short constant period, and plotting the measured pair of data to correspond the discharge current to a horizontal axis and the terminal voltage to a vertical axis, a graph shown in Fig. 3 is given. The characteristics of the current-voltage in increasing and decreasing discharge current shown in Fig. 3 can be approximated to flowing quadratic equations by a least squares method.

$$V = a1*I^2 + b1*I + c1 \ -----(1)$$

$$V = a2*I^2 + b2*I + c2 \ -----(2)$$

In Fig. 3, curves of approximated quadratic equations are drawn to overlap on.

In Fig. 3, a voltage difference (c1-c2) between an intersection point of the approximated curve of increasing current and an intersection point of the approximated curve of decreasing current is a voltage difference at no current of zero [A]. Then, the voltage difference is considered as a voltage drop caused only by a part by the concentration polarization newly occurred by discharging, not including the direct-current resistance and the activation polarization. Therefore, the voltage difference (c1-c2) is caused only by the concentration polarization, and the concentration polarization at the current of zero [A] is called Vpolc0. Any concentration polarization is considered as a value of multiplying a current value and a time of current flowing together, which is in proportion to A*h (or A*sec because of short time)

A method of calculating a concentration polarization at the peak current by using the concentration polarization at the current of zero [A] Vpolc0 will be described. The concentration polarization at the peak current is called Vpolcp. Vpolcp is shown by the following equation.

$$Vpolcp = [(A*sec \ at \ increasing \ current)/(A*sec \ at \ total$$
$$time \ for \ discharging)] * Vpolc0 \ -----(3)$$

A*sec at total time for discharging is shown by the following equation.

$$A*sec \ at \ total \ time \ for \ discharging = (A*sec \ at \ increasing$$
$$current + A*sec \ at \ decreasing \ current)$$

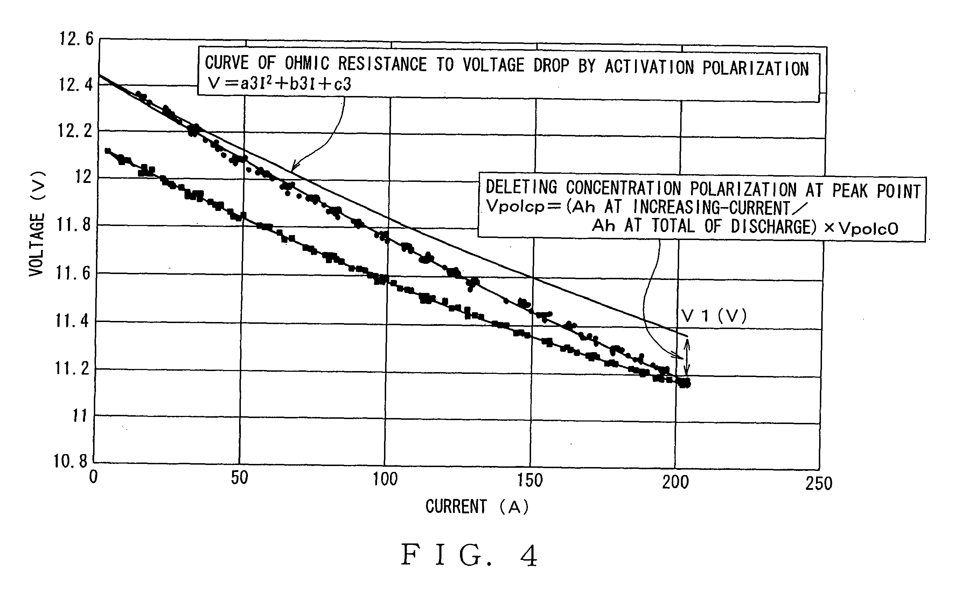

By adding the concentration polarization Vpolcp at the peak value as calculated above to the voltage at the peak value of increasing current of equation (1), the part by the concentration polarization at peak value is deleted as shown in Fig. 4. A voltage after deleting the part by the concentration polarization at peak value is called V1. V1 is shown in the following equation.

$$V1 = a1*Ip^2 + b1*Ip + c1 + Vpolcp$$

Ip is the current at the peak value.

An approximate equation of the characteristics of current-voltage of the direct-current resistance and the activation polarization as shown in Fig. 4 is tentatively shown as the following equation.

$$V = a3*I^2 + b3*I + c3 \ ------(4)$$

Since the activation polarization and the concentration polarization at the current of zero [A] before start of discharging is considered based on c1, c3=c1 is given by the equation (1). Assuming that the current increases rapidly from an initial condition of increasing the current, but reaction of the concentration polarization is slow and the reaction is almost not proceeded, differential values of the equations (1) and (4) at the current of zero [A] becomes equal to each other so that b3=b1 is given. Therefore, by substituting c3=c1 and b3=b1, the equation (4) will be rewritten as the followings.

$$V = a3*I^2 + b1\ I + c1\ -----(5)$$

a3 is the only unknown quantity.
After that, assigning a coordinate of the peak of increasing current to the equation (5), and straightening it about a3, the following equation can be given.

$$a3 = (V1 - b1*Ip - c1)/Ip^2\ -----(5)$$

Thus, the approximate equation of the current-voltage characteristics only by the direct-current resistance and a part by the activation polarization is given by the equation (5).
A method of deleting the part by the concentration polarization from the decreasing current curve will be described as follows. An equation of decreasing current of the direct-current resistance and the activation polarization can be given by the same method of deleting the concentration polarization at the current peak value. Defining two points other than the peak value as points A and B, concentration polarization VpolcA, VpolcB at the points A and B is given by the following equations.

$$VpolcA = [(A*sec\ from\ start\ of\ increasing\ current\ to\ point$$
$$A)/(A*sec\ at\ total\ time\ for\ discharging)]\ *\ Vpolc0\ -----(6)$$

$$VpolcB = [(A*sec\ from\ start\ of\ increasing\ current\ to\ point$$
$$B)/(A*sec\ at\ total\ time\ for\ discharging)]\ *\ Vpolc0\ -----(7)$$

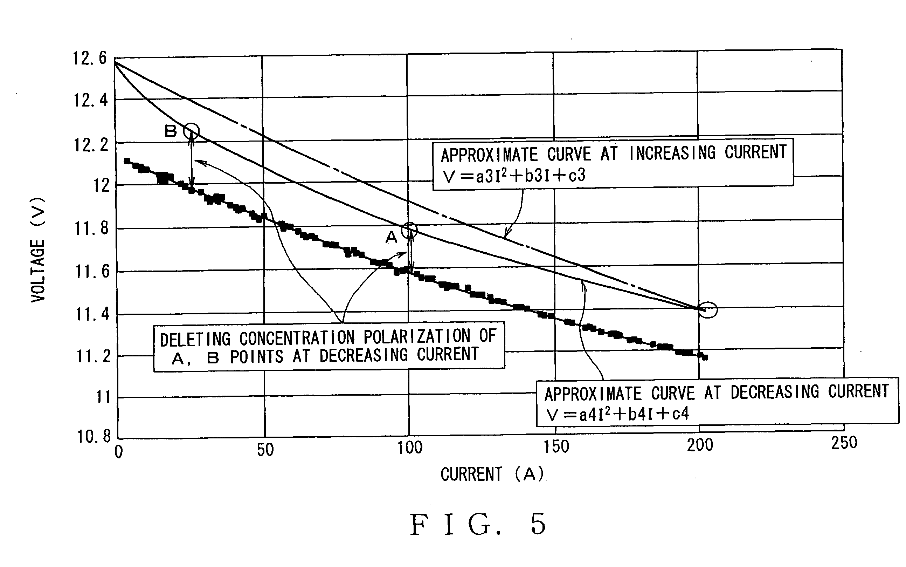

By using coordinates of three point of two points of deleting the part by concentration polarization other than the peak value given by the above equations (6), (7), and the peak value, a curve of decreasing current of the direct-current and the activation polarization shown by the following equation is given as shown in Fig. 5.

$$V = a4*I2 + b4*I + c4\ ------(8)$$

Coefficients a4, b4, c4 in the equation (8) can be determined by solving three simultaneous equations by assigning the current values and the voltages of the three points of points A, B and the peak point into the equation (8).
A method of calculating the direct-current resistance of the battery will be described. A difference between the curve of increasing current of the direct-current resistance and activation polarization excluding the concentration polarization shown by the above equation (5), and the curve of decreasing current of the direct-current resistance and activation polarization excluding the concentration polarization shown by the above equation (8) is according to the difference of the part by the activation polarization. Therefore, by deleting the part by the activation polarization from the above curves, the direct-current resistance can be given.
Watching the peak value of the both curves those the activation polarization is the same value to each other, a differential value R1 of increasing current and a differential value R2 of decreasing current at the peak value are given by the following equations.

$$R1 = 2*a3*Ip + b3 \quad ------(10)$$

$$R2 = 2*a4*Ip + b4 \quad ------(11)$$

A difference between the differential values R1 and R2 is caused by that one is the peak value of increasing of the activation polarization and the other is the peak value of decreasing. When the battery is discharged by using the electronic load to discharge as increasing from zero to 200 A within 0.25 sec and decreasing from the peak value to zero within the same time as a approximated discharge corresponding to the rush current, the both rates of change in the vicinity of the peak value are equal to each other, and it is considered that the characteristics of current-voltage by the direct-current resistance exists between the both. Therefore, by adding the differential values and dividing that by 2, the direct-current resistance R can be given by the following equation.

A case that the battery is discharged by using the electronic load as the approximated discharge corresponding to the rush current is described above. In case of actual vehicle, during the rush current flows in the field coil, the current reaches up to the peak, and cranking is acted by a current decreased down under the half of the peak current after reaching peak.

Therefore, the increasing current finishes in a short time of 3 msec. Such rapid current change almost never generate the concentration polarization at the peak value of the increasing current. The decreasing current flows in a long time of 150 msec comparing with the increasing current, so that, although decreasing current, a large concentration polarization is generated. During cranking, different phenomenon other than that during the rush current flows occurs. Discharge current and terminal voltage of the battery during cranking are not applied as data to determine the characteristics of current-voltage of decreasing current.

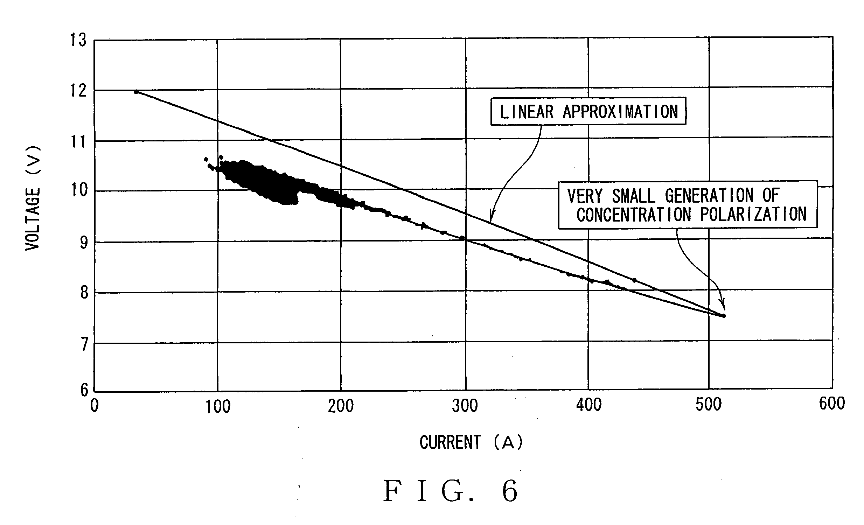

In such condition, the increasing current in the actual vehicle can be approximated by a straight line made with two points of a start point of increasing current and a peak value, as shown in Fig. 6. Generated value of the concentration polarization at the peak value of 500 [A] can be judged as zero [A]. In this case, a differential value at the peak value of increasing current uses a gradient of the approximated line of the increasing current.

In this case, a simple arithmetic average of the gradient of the approximated line of the increasing current and a gradient of a tangential line at the peak point of the approximated quadratic equation of the decreasing current cannot be applied. In such condition, generation of the concentration polarization completely differs between to-peak and after-peak, so that an assumption that the both ratios of change at the peak value are the same is not realized.

The direct-current resistance in this case is obtained by multiplying respectively change values per a unit of a current change of two terminal voltages at points corresponding to peak values of the first and second change values excluding the voltage drop by the concentration polarization, those are gradients, and ratios of times of monotonously increasing and monotonously decreasing against the total time of rush current flowing, and adding the results. In short, proportional ratios those are distributed by the monotonously increasing time against the total time and the monotonously decreasing time against the total time are multiplied with the each gradient and the result are added. Thereby, compensating an effect caused to each other by the activation polarization and the concentration polarization, the direct-current resistance can be obtained.

The activation polarization is generated in principal to have a value corresponding to the current. However, The value is affected by an amount of the concentration polarization, so that the value is not generated in principal. The smaller concentration polarization makes the activation polarization smaller, and the larger concentration polarization makes the activation polarization larger. In any case, the middle value between two changes per a unit of current-change of the terminal voltages at the points corresponding to the peak values of the two approximate equations excluding the voltage drop by the part by the concentration polarization can be measured as the direct-current resistance of the battery.

In a recent vehicle, an AC motor such as a magnet motor and a brushless DC motor, which requires a three-phase input power is used more frequently. In such motor, the rush current does not reach a peak value in a short time. It requires approximate 100 msec and the concentration polarization is generated in creasing current. Therefore, as same as the simulated discharging mentioned above, the current change curve of the increasing current must be approximated with a curve.

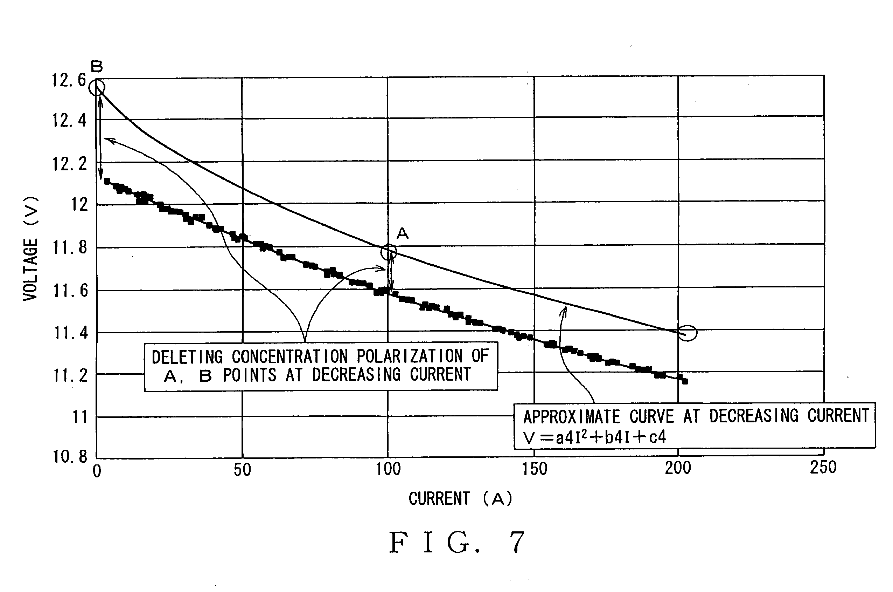

When approximating the direct-current resistance and the activation polarization at the decreasing current, for defining the peak value and two points other than the peak by applying the point of the current of zero [A] as the point B as shown in Fig. 7, calculation to obtain the approximate equation can be simplified.

If defining a point, a current of which is approximately half of the peak current, as a point where the concentration polarization is deleted, it can be linearly approximated to a straight line made by this point and the peak value. In this case, regarding the decreasing current, the gradient of the approximated straight line at the decreasing current is used as the differential value at the peak value. The direct-current resistance can be obtained accurately as same as that by using the quadratic curve.

In short, the middle value between two changes per the unit of current-change of the terminal voltages at the points corresponding to the peak values of the two approximate equations excluding the voltage drop by the part by the concentration polarization can be measured as the direct-current resistance of the battery.

In the case of using for example the starter motor, where a rush current flowing with generating the concentration polarization at the both of increasing discharging current and decreasing discharging current as the constant load, the method of measuring the direct-current resistance of the battery mounted on the vehicle will be described physically.

When the constant load is acted, the discharge current increasing monotonously over a steady-state value to peak value, and decreasing monotonously form the peak value to the steady-state value flows from the battery. The discharge current and the terminal voltage of the battery at the time are sampled at intervals of for example 100 micro-sec to measure them periodically, so that many couples of the discharge current and the terminal voltage are obtained.

The latest couple of the discharge current and the terminal voltage of the battery obtained above are stored, memorized and collected in a memory as rewritable storage device such as a RAM in a predetermined time. By the least-squares method, from couples of the discharge current and the terminal voltage stored, memorized and collected in the memory, two curved approximate equations (1) and (2) regarding to the characteristics of current-voltage of increasing discharging current and decreasing discharging current which show a relation between the terminal voltage and the discharging current. By deleting the voltage drop of the part by concentration polarization from the two approximate equations, an amended curved approximate equations excluding the part by the concentration polarization.

The voltage difference of the approximate equations (1) and (2) at the current of zero [A], flowing no current, is obtained as the concentration polarization, not as the voltage drop by the direct-current resistance and the activation polarization. The voltage drop of the part by concentration polarization at the peak value at the approximate equation (1) of characteristics of current-voltage of the increasing discharging current is obtained with the voltage difference. For that, the fact that the concentration polarization changes by a product of current-time, which is given by multiplying a value of current and a time of current flowing, is used.

After the voltage drop of the part by concentration polarization at the peak value at the approximate equation (1) of characteristics of current-voltage of the increasing discharging current is obtained, the constant and the coefficient of a leaner term of the approximate equation including the part of the concentration polarization are made the those of the approximate equation not including the part respectively the same. A coefficient of a quadratic term of the approximate equation not including the part is defined by that. Thereby, the amended curved approximate equation (5) of the approximate equation of the characteristics of current-voltage of the increasing discharging current is obtained.

After that, the approximate equation not including the part of concentration polarization will be given by the approximate equation (2) of the characteristics of current-voltage of the decreasing the discharging current. For that, two points deleting the part of the concentration polarization other than the peak value are obtained. For that, the fact that the concentration polarization changes by a product of current-time, which is given by multiplying a value of current and a time of current flowing, is used. When two points deleting the part by concentration polarization other than the peak value are obtained, the amended curved approximate equation (8), which is the approximate equation (2) of characteristics of current-voltage of the decreasing current amended by using three coordinates of the two points and the peak value is obtained.

The difference between the amended curved approximate equation, shown by equation (5), of the increasing current of the direct-current resistance and the activation polarization by deleting the part by the concentration polarization and the amended curved approximate equation, shown by equation (8), of the decreasing current of the direct-current resistance and the activation polarization by deleting the part by the concentration polarization is caused by the part by activation polarization. Therefore, the direct-current resistance can be given by deleting the part by the activation polarization. The difference between the differential values at the peak values of the increasing current and the decreasing current is caused by that the activation polarization of one is increasing and that of the other is decreasing. By watching the peak values of the both approximate equations, At a middle point between ratios of changes of the both in the vicinity of the peak value, the characteristics of current-voltage by the direct-current resistance exits. Therefore, the direct-current resistance can be obtained by multiplying the both differential values and respectively the time ratio in increasing monotonously and the time ratio in decreasing monotonously, and adding the results.

For example, assuming that the time of the increasing current is 3 msec, and the time.of the decreasing current is 100 msec, and defining the differential value of the increasing current at the peak value as Rpolk1, and the differential value of the decreasing current at the peak value as Rpolk2, the direct-current resistance Rn can be calculated as follows.

```
Rn = Rpolk1*100/103 + Rpolk2*3/103
```

The open-circuit voltage of the battery for the vehicle in a balanced condition can be detected by a method of measuring the terminal voltage in an open-circuit condition of subtracting a required load to supply dark current of computer from a load acted by electric power supply from the battery whenever a time enough to eliminate a certain charge/discharge polarization passes from turning an ignition switch of the vehicle OFF, as the latest open-circuit voltage in the balanced condition.

A method of obtaining a saturated polarization as a saturated value of voltage drop of the terminal voltage by the internal resistance other than the direct-current resistance will be described.

An energy of the battery to be discharged actually for a load is a capacity remained by subtracting a capacity corresponding to the voltage drop generated in the battery during discharging, that is the capacity to be not dischargeable by the internal resistance of the battery, from the charged capacity (product of the current and the time) corresponding to the value of open-circuit voltage of the battery.

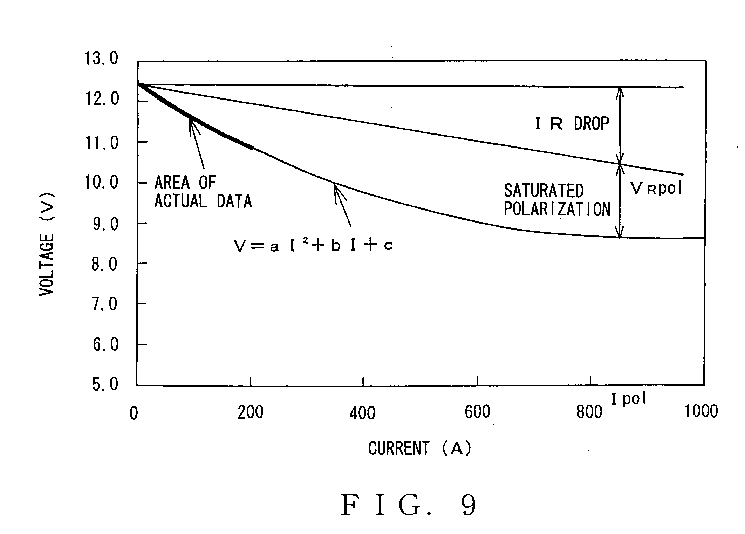

The voltage drop generated in the battery during discharging to satisfy a condition of detecting the saturated polarization can be divided to a part of the voltage drop (IR drop shown in Figure) by the direct-current resistance of the battery and a part of the voltage drop by the other internal resistance than the direct-current resistance (saturated polarization shown in Figure) as shown in Fig. 9.

The above voltage drop by the internal resistance other than the direct-current resistance of the battery does not increase and decrease synchronously with the discharge current. Therefore, in the battery, which the voltage drop by the direct-current resistance to be proportional to the discharge current, by obtaining the direct-current resistance by the above method, a timing when the voltage drop by the polarization reaches to the maximum value, that is the saturated value, must be detected.

From the discharge current and the terminal voltage of the battery measured at intervals in a short time discharge from the balanced condition, a following approximate equation of the characteristics of current-voltage can be given.

$$V = a*I^2 + b*I + c \quad ------(12)$$

The above terminal voltage V of the battery can be also shown as follows by the sum of a part of the voltage drop by the direct-current resistance Rn and a part of the voltage drop $V_R$ (voltage drop by polarization) by the internal resistance other than the part by the direct-current resistance.

$$V = c - (Rn*I + V_R) \quad ------(13)$$

The following equation can be led from the equations (12) and (13).

$$a*I + B*I = -(Rn*I + V_R) \quad -----(14)$$

By differentiating the above equation (14), the change ratio $dV_R/dI$ of the voltage drop by internal resistance other than the direct-current resistance of the battery can be obtained.

$$dV_R/dI = -2a*I - b - Rn \quad ----(15)$$

When the above change ratio $dV_R/dI$ becomes to zero, the discharge current corresponds to a saturated current of the terminal voltage drop Ipo1 (= -(Rn + b)/2a) when the part by internal resistance other than the direct-current resistance of the battery becomes the maximum value (the saturated value) .

When the discharge is from the balanced condition, by assigning the obtained saturated current of the terminal voltage drop Ipo1 as the discharge current I and the direct-current resistance Rn together into the equation (14), an obtained voltage drop $V_R$ (= -a*Ipol$^2$ - b*Ipol - Rn*Ipol) by polarization is defined as a saturated polarization $V_R$pol.

After obtaining the saturated polarization $V_R$pol showing the saturated value of the voltage drop by the internal resistance other than the direct-current resistance, SOH1 is obtained by using the direct-current resistance Rn and the saturated polarization $V_R$pol.

SOH1 can be given by calculating a ratio of the dischargeable capacity ADC, which is a value of subtracting the capacity not to be discharged by the internal resistance from the charge capacity, against a charge capacity SOC as an electric charge in the battery.

$$SOH1 = ADC/SOC*100 \ [\%]$$

A voltage value $V_{ADC}$ corresponding to the above dischargeable capacity ADC can be obtained as follows.

$$V_{ADC} = OCV0 - Rn*Ip - V_Rpol$$

herein, OCVn is an open-circuit voltage of the battery and Ip is the peak current of the discharge. As mentioned above, by subtracting $V_R$pol, the lowest voltage $V_{ADC}$ when the discharge continues can be obtained.
From the voltage $V_{ADC}$ obtained above, the dischargeable capacity ADC is given by a following converting equation in a voltage system.

$$ADC = \{(V_{ADC} - Ve)/(OCVf - OCVe)\}*100 \ [\%]$$

$$Ve = OCVf - I*R_{ref}$$

OCVf is an open-circuit voltage at a full-charge of a new battery, and OCVe is an open-circuit voltage at the end of discharge of the new battery. $R_{ref}$ is a design value of the direct-current resistance (ohmic resistance) of the new battery for the open-circuit voltage OCVn, that is the capacity of full-charge of the battery at start of discharge.
SOC can be given by the following equation.

$$SOC = \{(OCVn - OCVe)/(OCVf - OCVe)\}*100 \ [\%]$$

Therefore, the above SOH1 can be given by assigning the direct-current resistance Rn of the battery and the saturated polarization $V_R$pol to the following equation.

$$SOH1 = \{(V_{ADC} - Ve)/(OCVn - OCVe)\}*100 \ [\%] \ ---(16)$$

The method of calculating the second deterioration degree (SOH2) by decrease of the active material in the battery causing the decrease of the charge capacity of the battery will be described.
SOH2 is obtained based on decreased value of the capacity of the full-charge at any time against the capacity of the full-charge of the new battery.
Usually, regarding the battery by design, that is the new battery, the open-circuit voltage at full-charge OCVf and the voltage at the end of the discharge OCVe to be shown with a unit V (voltage), and an initial electric charge, shown with Ah (Ampere*time), which can be stored from the open-circuit voltage at full-charge to the voltage at the end of discharge can be predetermined. The above open-circuit voltage at full-charge OCVf corresponds to a capacity at full-charge of the new battery.
Therefore, if the open-circuit voltage at full-charge at any time of the battery OCVd is known, the decreased value of the capacity of the full-charge at any time against the capacity of the full-charge of the new battery can be given based on the OCVd and OCVf predetermined above.
A method of detecting OCVd will be described. In a vehicle, the battery is usually used in an in-between charge condition not to reach the full-charge condition. For improving a deterioration generated by repeating charge/discharge in the in-between charge condition, the battery is charged periodically to be in the full-charge condition for refreshing. OCVd can be detected by monitoring a decrease of an effect of charge at such refresh charge.
When the charge condition of the battery approaches to the full-charge condition in the refresh charge, the effect of charge is decreased by increase of gasification resistance caused by gassing (for example, decreased to near zero). Therefore, by calculating the effect of charge periodically in the refresh charge, and by monitoring the decrease of the effect of charge calculated as shown above, a time point of the battery reaching the full-charge condition can be known, so that the open-circuit voltage at the time point can be detected as OCVd.

Relation between the open-circuit voltage and the electric charge in the battery is changed comparing with new battery by decrease of an electrolyte. Therefore, by compensating OCVd with the value of the above change, the full-charge capacity and the second deterioration degree can be obtained more securely.

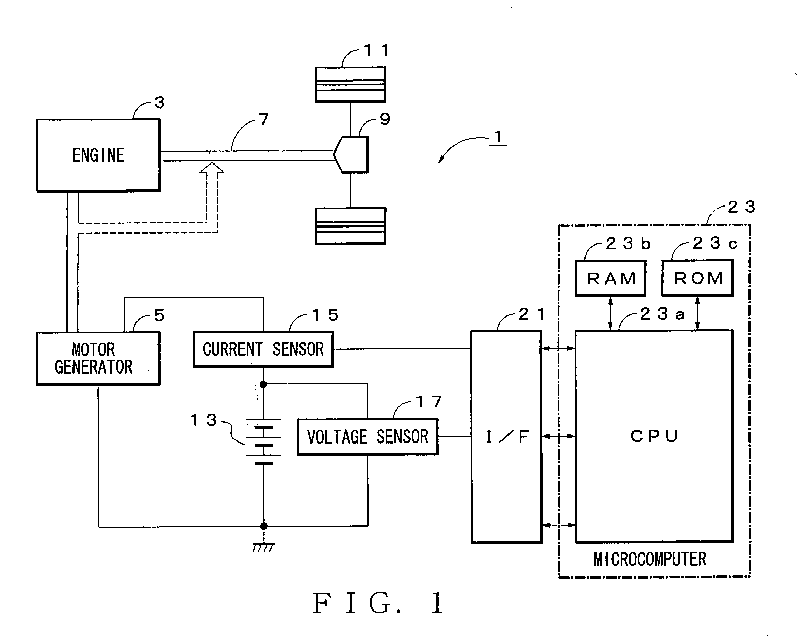

The battery condition monitor acting the method of monitoring the battery condition according to the present invention are described with reference to Fig. 1 showing a schematic block diagram of the monitor.

Fig. 1 is a block diagram of one embodiment of a battery condition monitor to perform the method of calculating the dischargeable capacity and the method of monitoring the battery condition according to the present invention. The battery condition monitor of the embodiment shown with mark 1 in Fig. 1 is installed in a hybrid vehicle with a motor generator 5 added on an engine 3.

In the hybrid vehicle, an output power of the engine 3 is transmitted from a drive shaft 7 through a differential case 9 to a wheel 11 for normal driving. At high load condition, the motor generator 5 is performed as a motor by electric power of a battery 13 and an output of the motor generator 5 added on the output of the engine 3 is transmitted from the drive shaft 7 to the wheel 11 for assist driving.

In the hybrid vehicle, the motor generator 5 is performed as a generator at decelerating and breaking to convert kinetic energy to electric energy for charging the battery 13 installed in the hybrid vehicle for supplying electric power to various loads.

The motor generator 5 is used as a self-starting motor to rotate a flywheel of the engine 3 forcibly when the engine 3 is started by turning a starter switch (not shown) ON.

The battery condition monitor 1 includes a current sensor 15 for detecting a discharge current I of the battery 13 for the motor generator 5 performing as the motor of assist driving and the self-starting motor and a charging current from the motor generator 5 as a generator to the battery 13, and a voltage sensor 17 connected in parallel with the battery 13 to have an infinitely large resistance for detecting a terminal voltage of the battery 13.

The current sensor 15 and the voltage sensor 17 mentioned above are provided in a circuit to be closed by turning an ignition switch ON.

The battery condition monitor 1 includes a microcomputer 23 in which outputs of the current sensor 15 and the voltage sensor 17 are inputted after A/D converted at an interface circuit 21 (shown by I/F hereafter), and includes furthermore a nonvolatile memory (NVM) 25.

The microcomputer 23 has a CPU 23a, a RAM 23b, a ROM 23c. The RAM 23b, the ROM 23c and the I/F 21 are connected with the CPU 23a, and a signal of ON/OFF of the ignition switch (not shown) is inputted into the CPU 23a.

The RAM 23b has a data area for storing various data and a work area to be used for various processing work. In the ROM 23c, a control program to make the CPU 23a operate various processing is stored.

SOH1 and SOH2 of the battery 13 is detected by the microcomputer 23 performing various detection at discharge mentioned above based on the outputs of the current sensor 15 and the voltage sensor 17. Thus, the microcomputer 23 performs as the first deterioration detector and the second deterioration detector. The microcomputer 23 also monitors the condition of the battery 13.

According to the above battery condition monitor, the deterioration including the irreversible and reversible deterioration can be monitored by SOH1, and the irreversible deterioration can be monitored. Therefore, by monitoring the battery condition based on the both of SOH1 and SOH2, the battery condition can be securely monitored.

EFFECT OF INVENTION

As mentioned above, according to the present invention as claimed in claims 1 and 4, deterioration including the irreversible and reversible deterioration can be monitored by the first deterioration degree, and the irreversible deterioration can be monitored by the second deterioration degree. Therefore, by monitoring the battery condition based on the first and second deterioration degrees, a battery condition monitor which can monitor securely the battery condition and a method thereof can be provided.

According to the present invention as claimed in claim 2, only by detecting the discharge current and the terminal voltage of the battery in various discharge, and processing the detected results, the direct-current resistance and the saturated polarization can be obtained. Therefore, the first deterioration degree can be detected in use of the battery. By obtaining the saturated polarization, the first deterioration degree at the point in which the dischargeable capacity decreases to the lowest when the discharge continues. Thereby, the battery condition monitor, which can monitor more securely the battery condition, can be provided.

According to the present invention as claimed in claim 3, by obtaining the value of decrease of the full-charge capacity, the battery condition monitor, which can obtain the second deterioration degree easily, can be provided.

**Claims**

1. A battery condition monitor for monitoring a condition of a battery, comprising:

   a first deterioration detector for detecting a first deterioration degree cause by increase of an internal resistance of the battery; and
   a second deterioration detector for detecting a second deterioration degree caused by decrease of active material of the battery to cause decrease of a charge capacity of the battery,
   wherein the condition of the battery is monitored based on the first deterioration degree and the second deterioration degree.

2. The battery condition monitor according to claim 1 , wherein the first deterioration detector obtains a direct-current resistance of the battery based on a discharge current and terminal voltage of the battery detected in a high-rate discharging, and obtains a saturated polarization, as a saturated value of a voltage drop by the internal resistance other than the direct-current resistance, based on the discharge current and the terminal voltage of the battery detected in discharging, and the direct-current resistance of the battery, and detects the first deterioration degree based on the direct-current resistance and the saturated polarization.

3. The battery condition monitor according to claim 1 or 2, wherein the second deterioration detector detects the second deterioration based on a decreasing value of the charge capacity at full-charge of the battery at any time corresponding to the charge capacity at full-charge of a new battery.

4. A method of monitoring a battery condition comprising a step of monitoring the battery condition based on a first deterioration degree caused by increase of an internal resistance of the battery and a second deterioration degree indicating a decreasing value of active material of the battery to cause decrease of a charge capacity of the battery.

F I G. 1

F I G. 2

F I G. 3

EP 1 615 043 A1

F I G. 4

EP 1 615 043 A1

F I G. 5

F I G. 6

EP 1 615 043 A1

F I G. 7

EP 1 615 043 A1

F I G. 8

F I G. 9

EP 1 615 043 A1

## INTERNATIONAL SEARCH REPORT

| International application No. |
| --- |
| PCT/JP2004/003925 |

| A. CLASSIFICATION OF SUBJECT MATTER |
| --- |
| Int.Cl$^7$  G01R31/36 |
| According to International Patent Classification (IPC) or to both national classification and IPC |

| B.  FIELDS SEARCHED |
| --- |
| Minimum documentation searched (classification system followed by classification symbols) |
| Int.Cl$^7$  G01R31/36 |

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

| C.  DOCUMENTS CONSIDERED TO BE RELEVANT | | |
| --- | --- | --- |
| Category* | Citation of document, with indication, where appropriate, of the relevant passages | Relevant to claim No. |
| Y<br>A | JP 2002-243814 A  (Yazaki Corp.),<br>28 August, 2002 (28.08.02),<br>Full text; all drawings<br>& US 2002/0053910 A1    & DE 10154530 A1 | 1,3,4<br>2 |
| Y<br>A | JP 8-339834 A  (Nippon Hoso Kyokai),<br>24 December, 1996 (24.12.96),<br>Full text; all drawings<br>(Family: none) | 1,3,4<br>2 |
| A | JP 2002-247702 A  (Yazaki Corp.),<br>30 August, 2002 (30.08.02),<br>Full text; all drawings<br>(Family: none) | 1-4 |

| ☐  Further documents are listed in the continuation of Box C. | ☐  See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 11 June, 2004 (11.06.04) | 06 July, 2004 (06.07.04) |

| Name and mailing address of the ISA/<br>Japanese Patent Office | Authorized officer |
| --- | --- |
| Facsimile No. | Telephone No. |

Form PCT/ISA/210 (second sheet) (January 2004)